# EUROPEAN PATENT APPLICATION

(11) **EP 4 848 327 A1**
(43) Date of publication of application: **02.12.2026**
(21) Application number: 26181739.9
(22) Date of filing: 28.05.2026
(51) Int. Cl.: H01H 85/47, F04D 33/00, H05K 7/20

(54) **HEAT DISSIPATION SYSTEM AND METHOD**

(30) Priority: 30.05.2025 CN 202510725663
(71) Applicant: Suzhou Littelfuse OVS Co., Ltd., Suzhou Jiangsu 215021 (CN)
(72) Inventor: Cheng, Du, Suzhou, 215021 (CN); Pan, Shangchun, Suzhou, 215021 (CN); Liu, Zhibo, Suzhou, 215021 (CN)
(74) Representative: Arnold & Siedsma

(57) **Abstract**

Heat dissipation apparatus, system and method in an electronic device. The apparatus includes a heat dissipation plate having a heat dissipation portion and a plate stand portion. The heat dissipation portion is coupled to the plate stand portion. Coupling of the heat dissipation portion and the plate stand portion forms an angle between the heat dissipation portion and the plate stand portion. The plate stand portion is coupled to the electronic device. The heat dissipation portion is positioned over at least a portion of the electronic device. During operation of the electronic device, the heat dissipation portion is configured to generate air flow proximate to at least a portion of the electronic device, thereby dissipating heat away from at least a portion of the electronic device.

## Description

### TECHNICAL FIELD

This disclosure relates generally to the field of circuit protection devices, and in particular, to dissipation of heat during operation of circuits having protection device.

### BACKGROUND

Electrical circuits that protect rechargeable elements, such as, for example, rechargeable electric vehicle (EV) batteries, are well-known. These rechargeable elements can be dangerous if they operate at a voltage that exceeds a safe limit. To protect against that, overcurrent protection devices are used, which withstand a maximum current allowed before current rise is interrupted.

Protection devices can include contactor devices (e.g., electrically controlled switches used for switching an electrical power circuit (e.g., in an electric vehicle)), fuses, etc. Fuses are used in electrical systems to protect against excessive current and devices and break when an overcurrent condition occurs. Fuses have many applications, e.g., from small circuit electronics to large-scale industrial applications. They can be used as protection devices as well as safety devices, such as, for example, when used in vehicles to protect against fires in response to vehicle accidents. Fuses come in a variety of sizes, shapes, and may have different structural features and operational characteristics. Protection devices can also be sealed to ensure safety and functionality of electronics under normal conditions and also in harsh or challenging environments. Sealing is designed to protect electronic components from environmental factors such as dust, ashes, harmful (e.g., corrosive) gasses and water, such as might be found, for example, in an engine compartment of a commercial vehicle. Such enclosures may be composed of various materials such as plastic, aluminum, and steel, and are used in a wide range of applications, from industrial settings to consumer electronics. However, during operation, existing protection devices generate a substantial amount of heat that cannot be easily removed due to the sealed nature of such devices, which can lead to catastrophic failure of devices and other electronic components coupled to them.

### SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

The current subject matter relates to an apparatus for dissipating heat during operation of an electronic device. The apparatus may include a heat dissipation plate having a heat dissipation portion and a plate stand portion. The heat dissipation portion may be coupled to the plate stand portion. Coupling of the heat dissipation portion and the plate stand portion forms an angle between the heat dissipation portion and the plate stand portion. The plate stand portion may be coupled to the electronic device. The heat dissipation portion may be positioned over at least a portion of the electronic device. During operation of the electronic device, the heat dissipation portion may be configured to generate air flow proximate to at least a portion of the electronic device, thereby dissipating heat away from at least a portion of the electronic device.

The current subject matter may include one or more of the following optional features. During operation of the electronic device, the heat dissipation portion may be configured to oscillate between a first position and a second position. Oscillation of the heat dissipation portion may be configured to generate air flow proximate to at least a portion of the electronic device.

The first position may be proximate to the at least a portion of the electronic device and the second position may be distal to the at least a portion of the electronic device.

The plate stand portion may be coupled to a mounting platform of the electronic device.

The electronic device may include a fuse component and a contactor relay component, the fuse component and the contactor relay component are coupled to a busbar component. The busbar component may provide an electrical connection between the fuse component and the contactor relay component. At least a portion of the electronic device may be at least one of: the fuse component, the contactor relay component, the busbar component, or any combination thereof. The heat dissipation portion may be positioned over at least one of: the fuse component, the contactor relay component, the busbar component, or any combination thereof. The electronic device may include a housing configured to enclose the fuse component, the contactor relay component, the busbar component, and the heat dissipation plate. The housing may be a sealed housing. At least a portion of the heat dissipated by the heat dissipation plate may be transferred to the housing.

At least one of the plate stand portion and the heat dissipation portion may be manufactured from at least one of: a metal, an alloy, plastic, a polymer, a composite material, a non-conductive material, or any combinations thereof.

The current subject matter relates to an electronic device, preferably as included in this apparatus which device may include a fuse component, a contactor relay component, and a busbar component. The fuse component and the contactor relay component may be coupled to the busbar component. The busbar component may be configured to provide an electrical connection between the fuse component and the contactor relay component. The device may also include a heat dissipation plate having a heat dissipation portion and a plate stand portion. The heat dissipation portion may be coupled to the plate stand portion. Coupling of the heat dissipation portion and the plate stand portion forms an angle between the heat dissipation portion and the plate stand portion. The plate stand portion may be coupled to the electronic device. The heat dissipation portion may be positioned over at least a portion of the electronic device. During operation of the electronic device, the heat dissipation portion may be configured to generate air flow proximate to at least a portion of the electronic device, thereby dissipating heat away from at least a portion of the electronic device.

The current subject matter may include one or more of the following optional features. During operation of the electronic device, the heat dissipation portion may be configured to oscillate between a first position and a second position. The first position may be proximate to at least a portion of the electronic device and the second position may be distal to at least a portion of the electronic device. Oscillation of the heat dissipation portion may be configured to generate air flow proximate to at least a portion of the electronic device.

The plate stand portion may be coupled to a mounting platform of the electronic device.

At least a portion of the electronic device may be at least one of: the fuse component, the contactor relay component, the busbar component, or any combination thereof. The heat dissipation portion may be positioned over at least one of: the fuse component, the contactor relay component, the busbar component, or any combination thereof. The electronic device may include a housing configured to enclose the fuse component, the contactor relay component, the busbar component, and the heat dissipation plate. The housing may be a sealed housing. At least a portion of the heat dissipated by the heat dissipation plate may be transferred to the housing.

At least one of the plate stand portion and the heat dissipation portion are manufactured from at least one of: a metal, an alloy, plastic, a polymer, a composite material, a non-conductive material, or any combinations thereof.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the discosure. In the drawings,
FIGS. 1A-F illustrate example electronic device, according to the current subject matter;
FIGS. 2A-C illustrate the electronic device having a heat dissipation plate for dissipating heat away from one or more components of the electronic device, according to the current subject matter; and
FIGS. 3A-B illustrate an example of heat dissipation provided by the heat dissipation plate shown in FIGS. 2A-C, according to the current subject matter.

### DETAILED DESCRIPTION

Various approaches in accordance with the present disclosure will now be described more fully hereinafter with reference to the accompanying drawings.

To address these and potentially other deficiencies of currently available solutions, the current subject matter relates to methods, systems, articles of manufacture, and the like that can, among other possible advantages, provide for a heat dissipation component that may be configured to dissipate heat from one or more components of an electronic device during its operation.

The current subject matter relates to an apparatus for dissipating heat during operation of an electronic device. The electronic device may be any electronic device that may be integrated into an electronic circuit and that may provide protection to such electronic circuit during operation (e.g., a fuse and contactor relay component for protecting one or more electronic circuit components of an automobile, etc.). The apparatus may include a heat dissipation plate that may be positioned over one or more components of the electronic device (e.g., a fuse component, a contactor relay component, one or more busbars or connectors that may electrically couple the fuse component and the contactor relay component and/or any other components, and/or any other components of the electronic device). The heat dissipation plate may include a heat dissipation portion and a plate stand portion. The plate stand portion may be coupled to the electronic device, e.g., to a mounting platform of the electronic device. The heat dissipation portion may be coupled to the plate stand portion. Alternatively, or in addition, the heat dissipation portion and the plate stand portion may form a unitary and/or integral plate. The heat dissipation portion and the plate stand portion may be so coupled so as to form an angle between the heat dissipation portion and the plate stand portion. The heat dissipation portion may be more flexible than the plate stand portion, thereby allowing the heat dissipation portion to oscillate between two positions. The heat dissipation portion may be positioned over at least a portion of the electronic device (e.g., the fuse component, the contactor relay component, the busbar component, and/or any other component of the electronic device, and/or any combination thereof).

During operation of the electronic device, as stated above, the heat dissipation portion of the heat dissipation plate may be configured to oscillate between the first position (e.g., bottom plate position) and a second position (e.g., upper plate position). The first portion of the heat dissipation portion may be proximate to at least a portion of the electronic device and the second position may be distal to at least a portion of the electronic device. Oscillation of the heat dissipation portion may be configured to generate air flow proximate to at least a portion of the electronic device. Air flow created by the heat dissipation portion may be configured to remove heat from one or more components of the electronic device, thereby cooling and preventing overheating of such components.

The electronic device may include a housing that may house or enclose the fuse component, the contactor relay component, the busbar component, the heat dissipation plate, and/or any other components of the electronic device. The housing may be a sealed housing. Further, at least a portion of the heat dissipated by the heat dissipation plate may be transferred to the housing, thereby cooling one or more components (e.g., fuse component, contactor relay component, busbar component(s), and/or any other components and/or any combination thereof). The heat dissipation plate, including one or more of its heat dissipation portion and plate stand portion, may be manufactured from at least one of: a metal, an alloy, plastic, a polymer, a composite material, a non-conductive material, and/or any other material, and/or any combinations thereof.

The current subject matter relates to an electronic device that may include the heat dissipation portion. The electronic device may include a housing that may be configured to house and/or enclose the fuse component, the contactor relay component, the busbar component that may be configured to provide electrical connection between the fuse component and the contactor relay component, and the heat dissipation plate, among any other components. The housing may be a sealed housing. The electronic device may be configured to be integrated into an electronic circuitry (e.g., an automobile electronic circuitry, a controller circuitry, a battery control circuitry, etc.) and may be configured to provide circuit protection to various electronic components in such electronic circuitry. During operation, electrical current may be supplied to the electronic device and upon determination that it exceeds a predetermined threshold, the electronic device may be configured to disconnect one or more electronic components of such circuitry (e.g., disconnect an electronic component from a power supply (e.g., a battery), etc.). If the electrical current does not exceed a predetermined threshold, the electronic device may continue to provide electrical connections between various devices, power supply, etc. The electrical current that passes through the electronic device may cause some of its components (e.g., the fuse component, the contactor relay component, the busbar(s), etc.) to generate heat.

To dissipate some of the heat generated by the components of the electronic device, the heat dissipation plate may be used to generate airflow proximate to the components of the electronic device. The airflow may be generated through oscillatory or vibrational movements of the heat dissipation portion of the heat dissipation plate. Such movements may be generated as a result of external forces being applied to the electronic device. For example, if the electronic device is positioned in an automobile circuitry, oscillatory/vibrational movements may be caused by the automobile's engine (e.g., through normal engine operational vibrations, etc.), driving, etc. The heat dissipation portion of the heat dissipation plate may be configured to oscillate between two positions - a bottom position (e.g., proximate to a component of the electronic device) and an upper position (e.g., distal from the component of the electronic device). Such movement may displace air underneath the heat dissipation plate causing the air to move, thereby creating a fanning motion, which, in turn, may cause dissipation of heat away from the component of the electronic device. The heat may be transferred (e.g., through normal thermal transfer process, etc.) to the housing of the electronic device.

The heat dissipation plate may be positioned over the busbar connecting the fuse component and the contactor relay component. As can be understood, the heat dissipation plate may be positioned over any other component of the electronic device, e.g., the fuse component, the contactor relay component, another busbar, etc.

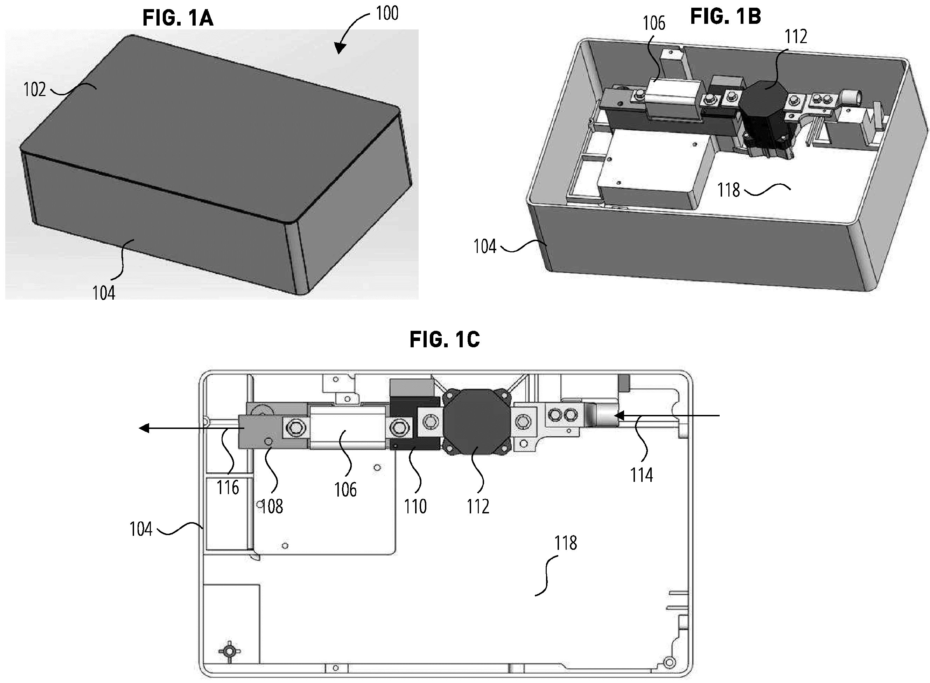

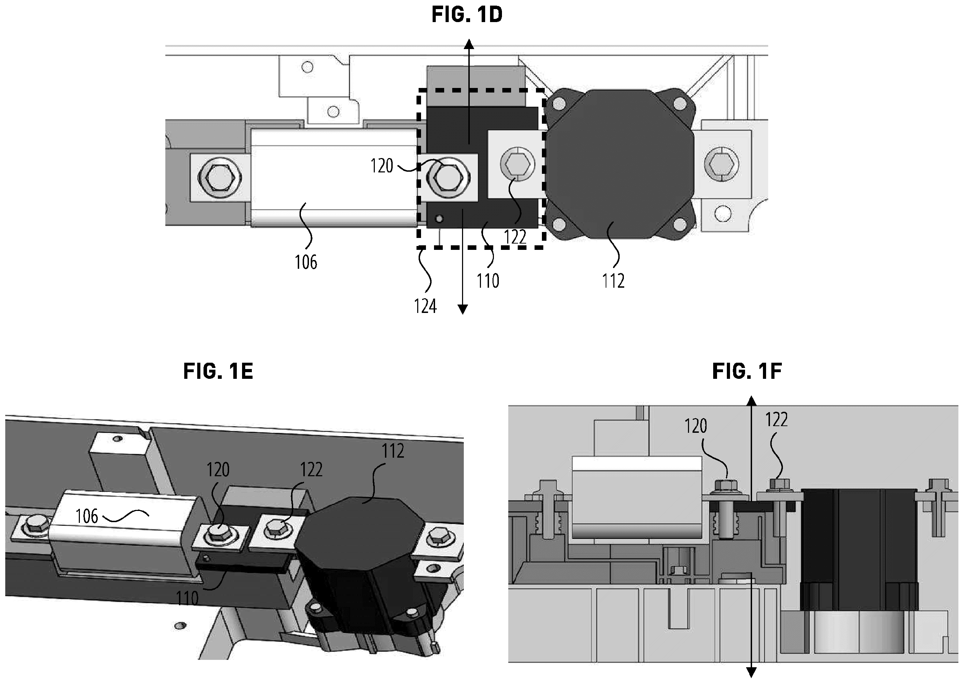

FIGS. 1A-F illustrate example electronic device 100, according to the current subject matter. FIG. 1A is a perspective view of the electronic device 100. FIG. 1B is a perspective view of the electronic device 100 with its cover removed, thereby showing interior of the electronic device 100. FIG. 1C is a top view of the electronic device 100 with its cover removed. FIG. 1D is a top view of a portion of an interior of the electronic device 100. FIG. 1E is a perspective of the portion of the electronic device 100 shown in FIG. 1E. FIG. 1F is a side view of another portion of the electronic device 100.

Referring to FIG. 1A, the electronic device 100 may include a cover 102 positioned over a housing 104. The housing 104 may be configured to contain and/or house of one or more components of the electronic device 100 (e.g., a fuse component, a contactor relay component, etc.). Once the cover 102 is positioned over the housing 104, the housing 104 may become sealed, thereby preventing debris from entering the housing interior 118 (as shown in FIG. 1B) and potentially, interfering with operation of one or more components of the electronic device 100.

The cover 102 and/or the housing 104 may be manufactured from any desired material. The material may include, for example, metal, an alloy, a composite material, plastic, polymer, non-conductive material, and/or any other material and/or any combination of materials. The cover 102 and/or the housing 104 may be manufactured from material that may be capable of preventing heat and/or any other elements from entering the housing interior 118 of the electronic device 100. The material may likewise support heat transfer from the housing interior 118 to the exterior of the electronic device 100. As can be understood, the material used to manufacture cover 102 and/or housing 104 may have any desired properties.A sealing gasket may be positioned between the cover 102 and the housing 104 to ensure a proper seal.

The electronic device 100 may be used to provide circuit protection to various electronic components of an electronic circuitry. For instance, the electronic device 100 may be incorporated into an automobile control circuitry (e.g., of an electric vehicle, gasoline-powered vehicle, etc.) and may provide a disconnect between a power source (e.g., a battery) and other electronic components to prevent damage to the electronic components, such as, in case of occurrence of overcurrent conditions.

FIGS. 1B and 1C illustrate the housing interior 118 of the electronic device 100. The housing interior 118 may be configured to contain and/or house one or more components of the electronic device 100. The electronic device 100 may include a fuse 106, a connector or a busbar 108, a busbar 110, and a contactor relay 112 among other components (e.g., connectors, wiring, etc.). The components 106-112 may be mounted on one or more mounting platforms. Each component may have its own mounting platform. Alternatively, or in addition, all components 106-112 may be mounted into a single mounting platform. The mounting platform may be a non-conductive mounting platform, such as, for example, to prevent undesired electrical connections between components 106-112. The components 106-112 may be secured to mounting platform(s) using bolts, screws, fasteners, welding, glue, and/or any other desired securing mechanisms.

The fuse 106 may include fuse terminals. The contactor relay 112 may likewise include contactor relay terminals. The fuse 106 and the contactor relay 112 may be electrically coupled using busbar 110. For instance, the busbar 110 may be an electrically conductive (e.g., metallic, etc.) plate and/or any connector, to which one of the fuse terminals of the fuse 106 and one of the contactor relay terminals of the contactor relay 112 may be coupled (e.g., using bolts, screws, fasteners, etc.). For example, as shown in FIGS. 1E-1F, the fuse 106 may be electrically and mechanically coupled to the busbar 110 using fuse connector 120. Similarly, the contactor relay 112 may be electrically and mechanically coupled to the busbar 110 using contactor relay connector 122.

Other terminals (e.g., terminals not coupled to the busbar 110) of the fuse 106 and contactor relay 112 may be coupled to other components of the electronic device 100. For example, the contactor relay 112 may be coupled to an input 114 (e.g., an electrical connector, an electrical plate, etc.) of the electronic device 100 using its other contactor relay terminal. The coupling of such contactor relay terminal may also be accomplished through use of bolts, screws, fasteners, welding, glue, and/or any other desired securing mechanisms. The input 114 may be configured to receive electrical current (e.g., from a power source, etc.). The fuse 106 may be coupled, via another busbar 108, to an output 116 of the electronic device 100. The busbar 108 may be similar to the busbar 110. Likewise, coupling of the busbar 110 and the other fuse terminal of the fuse 106 may be accomplished using bolts, screws, fasteners, welding, glue, and/or any other desired securing mechanisms. The output 116 may be coupled to various electronic components (e.g., controllers, processors, etc.) of electronic circuitry that the electronic device 100 may be coupled to and/or may be designed to protect. By being electrically coupled, the components 106-112 along with input 114 and output 116 create an electrical connection from one electronic component of the circuitry (e.g., a controller, etc.) to another (e.g., battery, etc.).

During operation of the electronic device 100, one or more components 106-112 may generate heat. The heat may be generated as a result of resistance by one or more components 106-112 to electrical current passing through the electronic device 100 from input 114 to output 116. For example, the heat may be generated by the fuse 106 and/or contactor relay 112. The heat may also be generated by the busbar 110 and/or busbar 108 through contact resistance. As a result, an increased temperature may be observed in and/or around busbar 110, such as, for example, as shown in FIG. 1D, by the heat area 124.

While the heat around (e.g., above, below, on each side, etc.) the heat area 124 may move in various directions (e.g., as shown by arrows in FIGS. 1D and 1F), little air convection and thus, heat dissipation from the heat area 124 occurs. This is because the electronic device 100 is sealed (e.g., using cover 102), thereby preventing air movement inside the housing interior 118 of the electronic device 100 and hence, cooling of any of the components 106-112 of the electronic device 100.

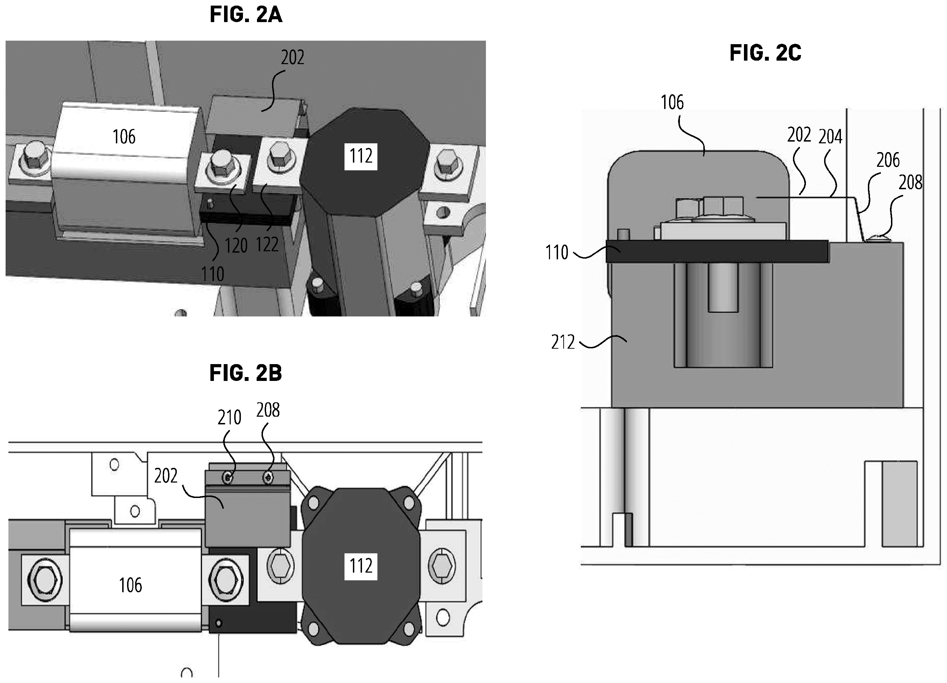

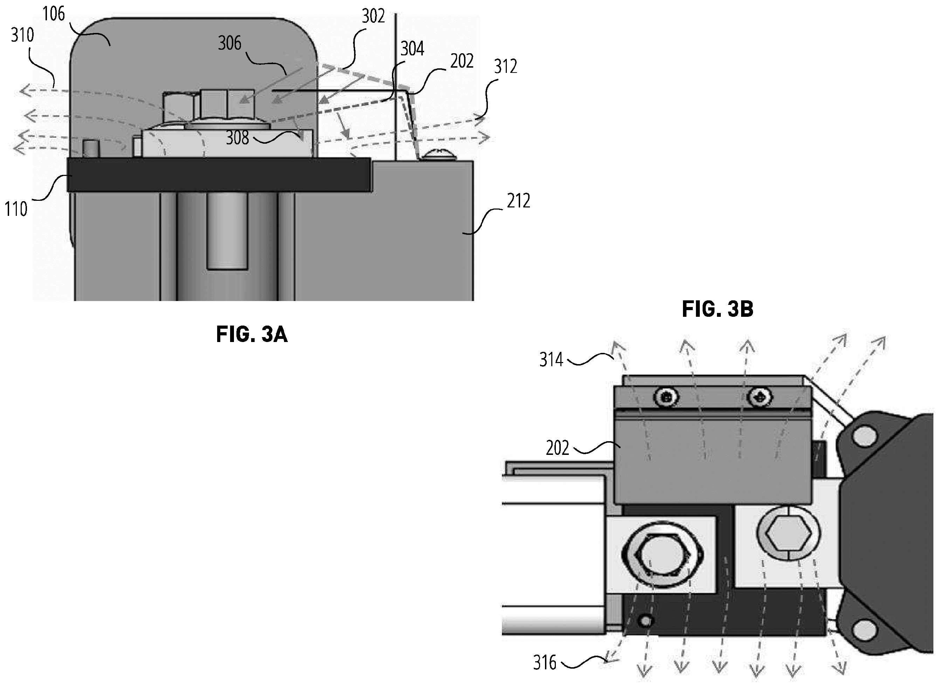

Overheating of any of the components 106-112 of the electronic device 100 may lead to failure of one or more such components, thereby causing interruption of current flow through the electronic device 100. For example, the failure may include, but not limited to, melting of connectors 120 and/or 122, failure of the contactor relay 112, fuse 106, and/or any other components. To address this, as discussed herein in connection with FIGS. 2A-C and 3A-B, the electronic device 100 may include a heat dissipation plate 202 that may increase movement of heated air away from one or more components 106-112, thereby cooling them.

FIGS. 2A-C illustrate the electronic device 100 having a heat dissipation plate 202 for dissipating heat away from one or more components 106-112 of the electronic device 100, according to the current subject matter. FIG. 2A illustrates a perspective view of a portion of the electronic device 100 showing the heat dissipation plate 202. FIG. 2B is a top view of the portion of the electronic device 100 shown in FIG. 2A. FIG. 2C is a side view of another portion of the electronic device 100 showing the heat dissipation plate 202.

The heat dissipation plate 202 may include a heat dissipation portion 204 and a plate stand portion 206. The heat dissipation portion 204 and the plate stand portion 206 may be coupled to one another and/or form a single, integral heat dissipation plate 202. The plate stand portion 206 may be coupled to a busbar mounting platform 212 of the electronic device 100 using one or more plate connector 208 and/or plate connector 210. As can be understood, any number of plate connectors 208, 210 may be used to secure the heat dissipation plate 202 to the busbar mounting platform 212. The busbar mounting platform 212 may also be used for mounting of the busbar 110, as shown in FIG. 2C. The heat dissipation plate 202 may be mounted to a mounting platform that may be separate from the busbar mounting platform 212. The plate stand portion 206 may be secured to the busbar mounting platform 212 using bolts, screws, fasteners, welding, glue, and/or any other desired securing mechanisms (which may form one or more plate connectors 208, 210).

The heat dissipation portion 204 and plate stand portion 206 may be disposed at an angle with respect to one another. This may allow the heat dissipation portion 204 to be disposed proximate to/over one or more components 106-112 of the electronic device 100 while the plate stand portion 206 may provide support to the heat dissipation portion 204 and allow it to be disposed above such component(s) 106-112 at a predetermined height. The plate stand portion 206 may also form an angle with respect to the busbar mounting platform 212. This may ensure a mounting location of the heat dissipation plate 202 to the busbar mounting platform 212 to be further away from any of the components 106-112 that the heat dissipation plate 202 may be designed to dissipate heat from. The angular dispositions of the heat dissipation portion 204 and the plate stand portion 206 may, for example, cause the heat dissipation portion 204 to be substantially parallel to an upper surface of the busbar mounting platform 212 and/or the busbar 110. As can be understood, the heat dissipation portion 204 might not be parallel to the upper surface of the busbar mounting platform 212 and/or busbar 110.

Both heat dissipation portion 204 and plate stand portion 206 may be manufactured from the same material (e.g., metal, alloy, plastic, polymer, plastic, composite material, non-conductive material, and/or any other material and/or any combination of materials). The heat dissipation portion 204 and plate stand portion 206 may have a different flexibility/rigidity. For example, the heat dissipation portion 204 may be more flexible than the plate stand portion 206. Greater flexibility of the heat dissipation portion 204 may allow the heat dissipation portion 204 to more easily oscillate and/or vibrate as a result of application of external forces (e.g., in the automobile example, the external forces may be vibratory forces generated as result of driving the vehicle), as shown in FIGS. 3A-B. At the same time, greater rigidity of the plate stand portion 206 may ensure stability of the heat dissipation plate 202 allowing the heat dissipation portion 204 to oscillate without interfering and/or contacting of the component(s) 106-112. Alternatively, or in addition, the heat dissipation portion 204 and the plate stand portion 206 may have the same flexibility/rigidity.

As shown in FIGS. 2A-C, the heat dissipation plate 202 may be positioned proximate and/or above the busbar 110. As can be understood, the heat dissipation plate 202 may be positioned proximate and/or above any other component 106-112 of the electronic device 100. The heat dissipation plate 202 may be positioned proximate to one or more components 106-112 and without being positioned over such component(s). This may allow the heat dissipation plate 202 to dissipate heat from the component(s) 106-112 without being positioned over them.

Further, more than one heat dissipation plate 202 may be used. For example, each of the fuse 106, busbar 108, busbar 110, and/or contactor relay 112 may include its own heat dissipation plate 202. Alternatively, or in addition, only some of the components 106-112 (e.g., fuse 106 and/or contactor relay 112) may be provided with the heat dissipation plate 202.

The heat dissipation plate 202 may have a width that may allow the heat dissipation plate 202 to extend over a single component 106-112 and/or over multiple components 106-112. As shown in FIGS. 2A-C, the heat dissipation plate 202 may have a width that extends over the busbar 110. As can be understood, the heat dissipation plate 202 may have any desired width.

FIGS. 3A-B illustrate an example of heat dissipation provided by the heat dissipation plate 202 shown in FIGS. 2A-C, according to the current subject matter. As discussed herein, one or more external force may cause the heat dissipation plate 202, and in particular, its heat dissipation portion 204 to oscillate between various positions. As shown in FIG. 3A, during oscillation, the heat dissipation portion 204 may be configured to oscillate between a first position or bottom plate position 304 and a second position or upper plate position 302. The plate stand portion 206 may also oscillate together with the heat dissipation portion 204. Alternatively, or in addition, the plate stand portion 206 may remain substantially unmoved.

Oscillation of the heat dissipation portion 204 from the upper plate position 302 to bottom plate position 304 generate various directions of ventilation. For example, upon initiation of a downward movement of the heat dissipation portion 204 from the upper plate position 302 to the bottom plate position 304, the heat dissipation portion 204 may force the air underneath the heat dissipation portion 204 to begin moving in a first downward direction creating ventilation 306, as shown by the solid arrows in FIG. 3A. As the heat dissipation portion 204 approaches the bottom plate position 304, the first downward direction may change causing the air to begin moving in a second downward direction creating ventilation 308, as shown by the solid arrows in FIG. 3A.

The ventilation 306 may trigger heat dissipation 310 away from the component (e.g., busbar 110) of electronic device 100, as shown by dashed arrows in FIG. 3A. Similarly, ventilation 308 may trigger heat dissipation 312 away from the component (e.g., busbar 110) and in an opposite direction of ventilation 306. The ventilations 306, 308 may create heat convection that may allow heat to travel away from the component(s) 106-112 and toward the housing interior 118 and/or walls of the housing 104. The heat may also be transferred (e.g., using thermal transfer) and/or absorbed by the walls of the housing 104. This cools the component(s) 106-112 (e.g., busbar 110), thereby preventing its overheating. As can be understood, the directions of ventilations 306, 308 and/or heat dissipations 310-316 (as shown in FIGS. 3A-B) are for exemplary, non-limiting purposes. Ventilation(s) and/or heat dissipation(s) may occur any desired directions.

As shown in FIG. 3B, the oscillation of the heat dissipation portion 204 may cause dissipation of heat in other directions and away from component(s) 106-112. For example, the heat may be dissipated by radially the heat dissipation portion 204, such as, in heat dissipation 314 and/or 316 directions. The directions and/or force of each of the ventilations/heat dissipations 310-316 created by the oscillation of the heat dissipation portion 204 may vary. These may depend on a strength of one or more external forces that may be experienced by the heat dissipation plate 202.

The electronic device 100 may include one or more vibration mechanisms that may cause oscillation of the heat dissipation portion 204. The vibration mechanisms may be housed inside the housing interior 118 of the electronic device 100 and/or be externally coupled to the electronic device 100.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

It is emphasized that the abstract of the disclosure is provided to allow a reader to quickly ascertain the nature of the technical disclosure. It is submitted with the understanding that it will not be used to interpret or limit the scope or meaning of the claims. In addition, in the foregoing detailed description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the detailed description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects. Further, the use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the scope of the appended claims.

In one aspect, an apparatus for dissipating heat during operation of an electronic device may include a heat dissipation plate having a heat dissipation portion and a plate stand portion; the heat dissipation portion is coupled to the plate stand portion, wherein coupling of the heat dissipation portion and the plate stand portion forms an angle between the heat dissipation portion and the plate stand portion; the plate stand portion is coupled to the electronic device; the heat dissipation portion is positioned over at least a portion of the electronic device; wherein during operation of the electronic device, the heat dissipation portion is configured to generate air flow proximate to the at least a portion of the electronic device, thereby dissipating heat away from the at least a portion of the electronic device.

The apparatus may also include wherein during operation of the electronic device, the heat dissipation portion is configured to oscillate between a first position and a second position, wherein oscillation of the heat dissipation portion is configured to generate air flow proximate to the at least a portion of the electronic device.

The apparatus may also include wherein the first position is proximate to the at least a portion of the electronic device and the second position is distal to the at least a portion of the electronic device.

The apparatus may also include wherein the plate stand portion is coupled to a mounting platform of the electronic device.

The apparatus may also include wherein the electronic device includes a fuse component and a contactor relay component, the fuse component and the contactor relay component are coupled to a busbar component, wherein the busbar component provides an electrical connection between the fuse component and the contactor relay component.

The apparatus may also include wherein the at least a portion of the electronic device is at least one of: the fuse component, the contactor relay component, the busbar component, or any combination thereof.

The apparatus may also include wherein the heat dissipation portion is positioned over at least one of: the fuse component, the contactor relay component, the busbar component, or any combination thereof.

The apparatus may also include wherein the electronic device includes a housing configured to enclose the fuse component, the contactor relay component, the busbar component, and the heat dissipation plate.

The apparatus may also include wherein the housing is a sealed housing.

The apparatus may also include wherein at least a portion of the heat dissipated by the heat dissipation plate is transferred to the housing.

The apparatus may also include wherein at least one of the plate stand portion and the heat dissipation portion are manufactured from at least one of: a metal, an alloy, plastic, a polymer, a composite material, a non-conductive material, or any combinations thereof.

In one aspect, an electronic device may include a fuse component; a contactor relay component; a busbar component, wherein the fuse component and the contactor relay component are coupled to the busbar component, wherein the busbar component is configured to provide an electrical connection between the fuse component and the contactor relay component; a heat dissipation plate having a heat dissipation portion and a plate stand portion, wherein the heat dissipation portion is coupled to the plate stand portion, wherein coupling of the heat dissipation portion and the plate stand portion forms an angle between the heat dissipation portion and the plate stand portion; the plate stand portion is coupled to the electronic device; the heat dissipation portion is positioned over at least a portion of the electronic device; wherein during operation of the electronic device, the heat dissipation portion is configured to generate air flow proximate to the at least a portion of the electronic device, thereby dissipating heat away from the at least a portion of the electronic device.

The electronic device may also include wherein during operation of the electronic device, the heat dissipation portion is configured to oscillate between a first position and a second position, wherein the first position is proximate to the at least a portion of the electronic device and the second position is distal to the at least a portion of the electronic device; wherein oscillation of the heat dissipation portion is configured to generate air flow proximate to the at least a portion of the electronic device.

The electronic device may also include wherein the plate stand portion is coupled to a mounting platform of the electronic device.

The electronic device may also include wherein the at least a portion of the electronic device is at least one of: the fuse component, the contactor relay component, the busbar component, or any combination thereof.

The electronic device may also include wherein the heat dissipation portion is positioned over at least one of: the fuse component, the contactor relay component, the busbar component, or any combination thereof.

The electronic device may also include wherein the electronic device includes a housing configured to enclose the fuse component, the contactor relay component, the busbar component, and the heat dissipation plate.

The electronic device may also include wherein the housing is a sealed housing.

The electronic device may also include wherein at least a portion of the heat dissipated by the heat dissipation plate is transferred to the housing.

The electronic device may also include wherein at least one of the plate stand portion and the heat dissipation portion are manufactured from at least one of: a metal, an alloy, plastic, a polymer, a composite material, a non-conductive material, or any combinations thereof.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

The present disclosure is not to be limited in scope by the specific implementations described herein. Indeed, other various implementations of and modifications to the present disclosure, in addition to those described herein, will be apparent to those of ordinary skill in the art from the foregoing description and accompanying drawings. Thus, such other implementations and modifications are intended to fall within the scope of the present disclosure. Furthermore, the present disclosure has been described herein in the context of a particular implementation in a particular environment for a particular purpose. Those of ordinary skill in the art will recognize the usefulness is not limited thereto and the present disclosure may be beneficially implemented in any number of environments for any number of purposes. Thus, the claims set forth below are to be construed in view of the full breadth of the present disclosure as described herein.

## Claims

1. An apparatus for dissipating heat during operation of an electronic device, comprising:
a heat dissipation plate having a heat dissipation portion and a plate stand portion;
the heat dissipation portion is coupled to the plate stand portion, wherein coupling of the heat dissipation portion and the plate stand portion forms an angle between the heat dissipation portion and the plate stand portion;
the plate stand portion is coupled to the electronic device;
the heat dissipation portion is positioned over at least a portion of the electronic device;
wherein during operation of the electronic device, the heat dissipation portion is configured to generate air flow proximate to the at least a portion of the electronic device, thereby dissipating heat away from the at least a portion of the electronic device.

2. The apparatus of claim 1, wherein during operation of the electronic device, the heat dissipation portion is configured to oscillate between a first position and a second position, wherein oscillation of the heat dissipation portion is configured to generate air flow proximate to the at least a portion of the electronic device, preferably
wherein the first position is proximate to the at least a portion of the electronic device and the second position is distal to the at least a portion of the electronic device.

3. The apparatus of any of the preceding claims, wherein the plate stand portion is coupled to a mounting platform of the electronic device.

4. The apparatus of any of the preceding claims, wherein the electronic device includes a fuse component and a contactor relay component, the fuse component and the contactor relay component are coupled to a busbar component, wherein the busbar component provides an electrical connection between the fuse component and the contactor relay component, preferably
wherein the at least a portion of the electronic device is at least one of: the fuse component, the contactor relay component, the busbar component, or any combination thereof.

5. The apparatus of claim 4, wherein the heat dissipation portion is positioned over at least one of: the fuse component, the contactor relay component, the busbar component, or any combination thereof.

6. The apparatus of claim 4 or 5, wherein the electronic device includes a housing configured to enclose the fuse component, the contactor relay component, the busbar component, and the heat dissipation plate, preferably
wherein the housing is a sealed housing.

7. The apparatus of claim 6, wherein at least a portion of the heat dissipated by the heat dissipation plate is transferred to the housing.

8. The apparatus of any of the preceding claims, wherein at least one of the plate stand portion and the heat dissipation portion are manufactured from at least one of: a metal, an alloy, plastic, a polymer, a composite material, a non-conductive material, or any combinations thereof.

9. An electronic device, comprising:
a fuse component;
a contactor relay component;
a busbar component, wherein the fuse component and the contactor relay component are coupled to the busbar component, wherein the busbar component is configured to provide an electrical connection between the fuse component and the contactor relay component;
preferably, a heat dissipation plate having a heat dissipation portion and a plate stand portion, wherein
the heat dissipation portion is couplable to the plate stand portion, wherein coupling of the heat dissipation portion and the plate stand portion forms an angle between the heat dissipation portion and the plate stand portion;
the plate stand portion is coupled to the electronic device;
the heat dissipation portion is positionable over at least a portion of the electronic device;
wherein during operation of the electronic device, the heat dissipation portion is configured to generate air flow proximate to the at least a portion of the electronic device, thereby dissipating heat away from the at least a portion of the electronic device.

10. The electronic device of claim 9, wherein during operation of the electronic device, the heat dissipation portion is configured to oscillate between a first position and a second position, wherein the first position is proximate to the at least a portion of the electronic device and the second position is distal to the at least a portion of the electronic device;
wherein oscillation of the heat dissipation portion is configured to generate air flow proximate to the at least a portion of the electronic device.

11. The electronic device of claim 9 or 10, wherein the plate stand portion is coupled to a mounting platform of the electronic device, and/or
wherein the at least a portion of the electronic device is at least one of: the fuse component, the contactor relay component, the busbar component, or any combination thereof, preferably
wherein the heat dissipation portion is positioned over at least one of: the fuse component, the contactor relay component, the busbar component, or any combination thereof.

12. The electronic device of claim 11, wherein the electronic device includes a housing configured to enclose the fuse component, the contactor relay component, the busbar component, and the heat dissipation plate, preferably, wherein the housing is a sealed housing.

13. The electronic device of claim 12, wherein at least a portion of the heat dissipated by the heat dissipation plate is transferred to the housing.

14. The electronic device of any of the preceding claims 9-13, wherein at least one of the plate stand portion and the heat dissipation portion are manufactured from at least one of: a metal, an alloy, plastic, a polymer, a composite material, a non-conductive material, or any combinations thereof.

15. An apparatus for dissipating heat during operation of an electronic device, comprising an electronic device according to any of the preceding claims 9-14 and a heat dissipation portion positioned over at least a portion of the electronic device.
